# FASCICULE DE BREVET EUROPEEN

(11) **EP 2 533 419 B1**
(45) Date de publication et mention de la délivrance du brevet: **13.08.2014**
(21) Numéro de dépôt: 12170242.7
(22) Date de dépôt: 31.05.2012
(51) Int. Cl.: H03F 1/32, H04B 7/14

(54) **Système d'amplification de signaux générés par une unité de génération de signaux d'un satellite**
Verstärkungssystem von Signalen, die von einer Signalerzeugungseinheit eines Satelliten erzeugt werden
System for amplifying signals generated by a signal-generation unit of a satellite

(30) Priorité: 10.06.2011 FR 1101782
(43) Date de publication de la demande: 12.12.2012
(73) Titulaire: Thales, 92200 Neuilly Sur Seine (FR)
(72) Inventeur: Senant, Eric, 31290 Cessales (FR); Peyrotte, Christian, 31100 Toulouse (FR); Fernet, Charles, 31860 Labarthe sur Leze (FR)
(74) Mandataire: Brunelli, Gérald

(56) Documents cités:
- EP-A1- 1 429 453

## Description

La présente invention porte sur un système d'amplification de signaux générés par une unité de génération de signaux d'un satellite.

Les systèmes d'amplification de satellites, par exemple de communication ou de navigation, sont utilisés dans leur zone de rendement optimal, induisant, de fait, une réponse en puissance s'avérant non-linéaire.

Ces non-linéarités entrainent des remontées de puissance (produits d'inter-modulation) hors bande utile, ou "spurious" en langue anglo-saxonne, devant être filtrées à haute puissance, afin de respecter la réglementation des fréquences.

Aussi, la mise en oeuvre de tels traitements augmentent et compliquent la charge utile du satellite, tant en masse qu'en volume.

Il est connu des techniques de linéarisation de l'amplificateur par pré-distorsion numérique à la génération du signal, tel qu'illustré par exemple par le par le brevet US 6 549 067 B1.

De tels modes de réalisation imposent une largeur de bande élevé pour l'étage RF ou étage radiofréquences, ce qui implique un fort impact en terme de charge utile du satellite.

Il est également connu des techniques à base de linéarisateurs matériels réalisant une compensation des non-linéarités en entrée d'un dispositif d'amplification par une émulation, en opposition de phase des non-linéarités, en puissance, notamment au moyen de diodes, tel qu'illustré par exemple par la demande de brevet français FR 2 722 350.

De tels modes de réalisation sont peu efficaces pour les amplificateurs à transistors communément employés sur les satellites.

Un but de l'invention est de pallier les problèmes précédemment cités.

Il est proposé, selon un aspect de l'invention, un Système d'amplification de signaux générés par une unité de génération de signaux d'un satellite, comprenant :
- une première voie comprenant un premier filtre numérique passe-bande à réponse impulsionnelle finie pour filtrer hors de sa bande utile des signaux numériques générés par ladite unité et un premier convertisseur numérique/analogique disposé en sortie dudit premier filtre numérique,
- des moyens de transposition de fréquence pour convertir un signal en bande de base ou en fréquence intermédiaire en un signal en bande de porteuse, et
- un dispositif d'amplification comprenant un pré-amplificateur et un amplificateur,
**caractérisé en ce qu'**il comprend, en outre :
- une deuxième voie comprenant un deuxième filtre numérique passe-bande à réponse impulsionnelle finie pour filtrer hors de sa bande utile des signaux numériques générés par ladite unité, des moyens de gain disposés en sortie dudit deuxième filtre numérique, un oscillateur à commande numérique asservi en phase disposé en sortie desdits moyens de gain, et un deuxième convertisseur numérique/analogique disposé en sortie dudit oscillateur à commande numérique, et
- un dispositif recombineur pour sommer les signaux desdites première et deuxième voies.

Un tel système permet de concentrer l'efficacité du procédé sur la bande de fréquence impactée par le phénomène de non-linéarités, et non de façon globale comme les proposent les solutions existantes. Ceci permet alors potentiellement une simplification de la chaîne complète par suppression du filtrage de sortie à haute puissance.

Selon un mode de réalisation, lesdits moyens de transposition de fréquence sont disposés entre la sortie dudit dispositif recombineur et l'entrée dudit dispositif d'amplification.

En ce cas, un seul dispositif de transposition de fréquence et d'amplification sont requis à la fois pour le signal utile et le signal de compensation.

Dans un mode de réalisation, lesdits moyens de transposition de fréquence comprennent un oscillateur local, un mélangeur adapté pour additionner en fréquence, par multiplication, le signal d'entrée desdits moyens de transposition de fréquence et le signal de sortie de l'oscillateur local, et un troisième filtre passe-bande analogique pour isoler le résultat de ladite multiplication.

Selon un autre mode de réalisation, lesdits moyens de transposition de fréquence comprennent :
- des premiers sous-moyens de transposition de fréquence disposés sur la première voie entre la sortie dudit premier convertisseur et l'entrée dudit sommateur, et
- des deuxièmes sous-moyens de transposition de fréquence disposés sur la deuxième voie entre la sortie dudit deuxième convertisseur (CNA2) et l'entrée dudit sommateur.

En ce cas, la largeur de bande utile du dispositif de transposition de fréquence dédié au signal utile (première voie) peut être limitée à la bande utile du signal.

Dans un mode de réalisation, lesdits premiers et/ou deuxièmes sous-moyens de transposition de fréquence comprennent respectivement un oscillateur local, un mélangeur adapté pour additionner en fréquence, par multiplication, le signal d'entrée desdits sous-moyens de transposition de fréquence et le signal de sortie de l'oscillateur local, et un troisième filtre passe-bande analogique pour isoler le résultat de ladite multiplication.

Ainsi, le signal de compensation pourra être amplifié linéairement, ce qui simplifie l'asservissement de cette compensation.

L'invention sera mieux comprise à l'étude de quelques modes de réalisation décrits à titre d'exemples nullement limitatifs et illustrés par les dessins annexés sur lesquels :
- la figure 1 illustre schématiquement un mode de réalisation d'un système d'amplification de signaux générés par une unité de génération de signaux d'un satellite, selon un aspect de l'invention ; et
- la figure 2 illustre schématiquement un autre mode de réalisation d'un système d'amplification de signaux générés par une unité de génération de signaux d'un satellite, selon un aspect de l'invention.

Sur l'ensemble de figures, les éléments ayant les mêmes références sont similaires.

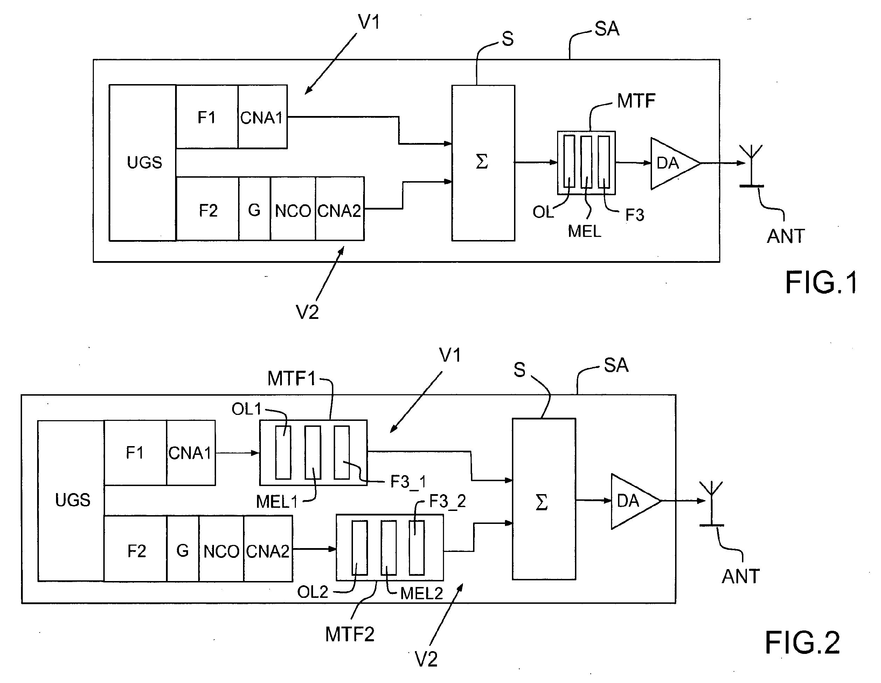

La figure 1 représente schématiquement un système d'amplification SA de signaux générés par une unité de génération de signaux UGS d'un satellite. Le système d'amplification SA comprend une première voie V1 munie d'un premier filtre numérique passe-bande F1 à réponse impulsionnelle finie pour filtrer hors de sa bande utile des signaux numériques générés par l'unité UGS, et un premier convertisseur numérique/analogique CNA1 disposé en sortie dudit premier filtre numérique F1. Le système d'amplification SA comprend également un module de transposition de fréquence MTF pour convertir un signal en bande de base ou en fréquence intermédiaire en un signal en bande de porteuse, et un dispositif d'amplification DA comprenant un pré-amplificateur et un amplificateur.

Le système d'amplification SA comprend, en outre, une deuxième voie V2 comprenant un deuxième filtre numérique passe-bande F2 à réponse impulsionnelle finie pour filtrer hors de sa bande utile des signaux numériques générés par l'unité UGS, un module de gain G disposés en sortie dudit deuxième filtre numérique F2, un oscillateur à commande numérique NCO asservi en phase disposé en sortie du module de gain G, et un deuxième convertisseur numérique/analogique CNA2 disposé en sortie de l'oscillateur à commande numérique NCO, et un dispositif recombineur S pour sommer les signaux des première et deuxième voies V1, V2.

Le module de transposition de fréquence MTF est disposé entre la sortie du dispositif recombineur S et l'entrée du dispositif d'amplification DA.

En l'espèce, le module de transposition de fréquence MTF comprend un oscillateur local OL, un mélangeur MEL adapté pour additionner en fréquence, par multiplication, le signal d'entrée du module de transposition de fréquence MTF et le signal de sortie de l'oscillateur local OL, et un troisième filtre passe-bande analogique F3 pour isoler le résultat de ladite multiplication.

L'oscillateur local OL définit la fréquence de porteuse à laquelle le signal recombiné sera modulé. Le filtre passe-bande analogique F3 permet de limiter l'entrée du dispositif d'amplification DA à la bande utile du signal, y compris la compensation.

Le mode de réalisation de la figure 1 tire partie de l'éventuelle capacité du module MTF de gérer à la fois le signal utile et le signal de compensation.

La figure 2 représente schématiquement un système d'amplification SA de signaux générés par une unité de génération de signaux UGS d'un satellite. Le système d'amplification SA comprend une première voie V1 munie d'un premier filtre numérique passe-bande F1 à réponse impulsionnelle finie pour filtrer hors de sa bande utile des signaux numériques générés par l'unité UGS, et un premier convertisseur numérique/analogique CNA1 disposé en sortie dudit premier filtre numérique F1. Le système d'amplification SA comprend également un module de transposition de fréquence MTF pour convertir un signal en bande de base ou en fréquence intermédiaire en un signal en bande de porteuse, et un dispositif d'amplification DA comprenant un pré-amplificateur et un amplificateur.

Le système d'amplification SA comprend, en outre, une deuxième voie V2 comprenant un deuxième filtre numérique passe-bande F2 à réponse impulsionnelle finie pour filtrer hors de sa bande utile des signaux numériques générés par l'unité UGS, un module de gain G disposés en sortie dudit deuxième filtre numérique F2, un oscillateur à commande numérique NCO asservi en phase disposé en sortie du module de gain G, et un deuxième convertisseur numérique/analogique CNA2 disposé en sortie de l'oscillateur à commande numérique NCO, et un dispositif recombineur S pour sommer les signaux des première et deuxième voies V1, V2.

Le module de transposition de fréquence MTF comprend un module de transposition de fréquence MTF comprenant :
- un premier sous-module de transposition de fréquence MTF1 disposé sur la première voie V1 entre la sortie du premier convertisseur CNA1 et l'entrée du sommateur S, et
- un deuxième sous-module de transposition de fréquence MTF2 disposé sur la deuxième voie V2 entre la sortie du deuxième convertisseur CNA2 et l'entrée du sommateur S.

Les premier et/ou deuxième sous-modules de transposition de fréquence MTF1, MTF2 comprennent respectivement un oscillateur local OL1, OL2, un mélangeur MEL1, MEL2 adapté pour additionner en fréquence, par multiplication, le signal d'entrée des sous-modules de transposition de fréquence MTF1, MTF2 et le signal de sortie de l'oscillateur local OL1, OL2, et un troisième filtre passe-bande analogique F3_1, F3_2 pour isoler le résultat de ladite multiplication, ce qui permet de limiter l'occupation spectrale des signaux à l'entrée du dispositif d'amplification DA.

Le mode de réalisation de la figure 2, simplifie l'asservissement en gain et synchronisation du signal de compensation.

## Revendications

1. Système d'amplification (SA) de signaux générés par une unité (UGS) de génération de signaux d'un satellite, comprenant :
- une première voie (V1) comprenant un premier filtre numérique passe-bande (F1) à réponse impulsionnelle finie pour filtrer hors de sa bande utile des signaux numériques générés par ladite unité (UGS) et un premier convertisseur numérique/analogique (CNA1) disposé en sortie dudit premier filtre numérique (F1),
- des moyens de transposition de fréquence (MTF) pour convertir un signal en bande de base ou en fréquence intermédiaire en un signal en bande de porteuse, et
- un dispositif d'amplification (DA) comprenant un pré-amplificateur et un amplificateur,
**caractérisé en ce qu'**il comprend, en outre :
- une deuxième voie (V2) comprenant un deuxième filtre numérique passe-bande (F2) à réponse impulsionnelle finie pour filtrer hors de sa bande utile des signaux numériques générés par ladite unité (UGS), des moyens de gain (G) disposés en sortie dudit deuxième filtre numérique (F2), un oscillateur à commande numérique (NCO) asservi en phase disposé en sortie desdits moyens de gain (G), et un deuxième convertisseur numérique/analogique (CNA2) disposé en sortie dudit oscillateur à commande numérique (NCO), et
- un dispositif recombineur (S) pour sommer les signaux desdites première et deuxième voies (V1, V2).

2. Système (SA) selon la revendication 1, dans lequel lesdits moyens de transposition de fréquence (MTF) sont disposés entre la sortie dudit dispositif recombineur (S) et l'entrée dudit dispositif d'amplification (DA).

3. Système (SA) selon la revendication 2, dans lequel lesdits moyens de transposition de fréquence (MTF) comprennent un oscillateur local (OL), un mélangeur (MEL) adapté pour additionner en fréquence, par multiplication, le signal d'entrée desdits moyens de transposition de fréquence (MTF) et le signal de sortie de l'oscillateur local (OL), et un troisième filtre passe-bande analogique (F3) pour isoler le résultat de ladite multiplication.

4. Système (SA) selon la revendication 1, dans lequel lesdits moyens de transposition de fréquence (MTF) comprennent :
- des premiers sous-moyens de transposition de fréquence (MTF1) disposés sur la première voie (V1) entre la sortie dudit premier convertisseur (CNA1) et l'entrée dudit sommateur (S), et
- des deuxièmes sous-moyens de transposition de fréquence (MTF2) disposés sur la deuxième voie (V2) entre la sortie dudit deuxième convertisseur (CNA2) et l'entrée dudit sommateur (S).

5. Système (SA) selon la revendication 4, dans lequel lesdits premiers et/ou deuxièmes sous-moyens de transposition de fréquence (MTF1, MTF2) comprennent respectivement un oscillateur local (OL1, OL2), un mélangeur (MEL1, MEL2) adapté pour additionner en fréquence, par multiplication, le signal d'entrée desdits sous-moyens de transposition de fréquence (MTF1, MTF2) et le signal de sortie de l'oscillateur local (OL1, OL2), et un troisième filtre passe-bande analogique (F3_1, F3_2) pour isoler le résultat de ladite multiplication.

## Patentansprüche

1. System (SA) zum Verstärken von Signalen, die von einer Einheit (UGS) zum Erzeugen von Signalen in einem Satelliten erzeugt werden, das Folgendes umfasst:
- einen ersten Kanal (V1), der ein erstes digitales Bandpassfilter (F1) mit finiter Impulsantwort zum Filtern von von der Einheit (UGS) erzeugten digitalen Signalen außerhalb ihres Nutzbandes und einen ersten Digital/Analog-Wandler (CNA1), der am Ausgang des ersten digitalen Filters (F1) angeordnet ist, umfasst;
- Frequenzumsetzmittel (MTF) zum Umwandeln eines Basisbandsignals oder eines Zwischenfrequenzsignals in ein Trägerbandsignal; und
- ein Verstärkungsgerät (DA), das einen Vorverstärker und einen Verstärker umfasst,
**dadurch gekennzeichnet, dass** es ferner Folgendes umfasst:
- einen zweiten Kanal (V2), der ein zweites digitales Bandpassfilter (F2) mit finiter Impulsantwort zum Filtern von von der Einheit (UGS) erzeugten digitalen Signalen außerhalb ihres Nutzbandes umfasst, Verstärkungsmittel (G), die am Ausgang des zweiten digitalen Filters (F2) angeordnet sind, einen digital gesteuerten Oszillator (NCO) mit geregelter Phase, der am Ausgang der Verstärkungsmittel (G) angeordnet ist, und einen zweiten Digital/Analog-Wandler (CNA2), der am Ausgang des digital gesteuerten Oszillators (NCO) angeordnet ist; und
- eine Rekombinationsvorrichtung (S) zum Addieren der Signale des ersten und zweiten Kanals (V1, V2).

2. System (SA) nach Anspruch 1, wobei die Frequenzumsetzmittel (MTF) zwischen dem Ausgang der Rekombinationsvorrichtung (S) und dem Eingang der Verstärkungsvorrichtung (DA) angeordnet ist.

3. System (SA) nach Anspruch 2, wobei die Frequenzumsetzmittel (MTF) einen Lokaloszillator (OL), einen Mischer (MEL) zum Summieren der Frequenzen, durch Multiplikation, der Eingangssignale der Frequenzumsetzmittel (MTF) und des Ausgangssignals des Lokaloszillators (OL), und ein drittes analoges Bandpassfilter (F3) zum Isolieren des Ergebnisses der Multiplikation umfasst.

4. System (SA) nach Anspruch 1, wobei die Frequenzumsetzmittel (MTF) Folgendes umfassen:
- erste Frequenzumsetzsubmittel (MTF1), die auf dem ersten Kanal (V1) zwischen dem Ausgang des ersten Wandlers (CNA1) und dem Eingang des Addierers (S) angeordnet sind; und
- zweite Frequenzumsetzsubmittel (MTF2), die auf dem zweiten Kanal (V2) zwischen dem Ausgang des zweiten Wandlers (CNA2) und dem Eingang des Addierers (S) angeordnet sind.

5. System (SA) nach Anspruch 4, wobei die ersten und/oder zweiten Frequenzumsetzsubmittel (MTF1, MTF2) jeweils einen Lokaloszillator (OL1, OL2), einen Mischer (MEL1, MEL2) zum Addieren der Frequenzen, durch Multiplikation, der Eingangssignale der Frequenzumsetzsubmittel (MTF1, MTF2) und des Ausgangssignals des Lokaloszillators (OL1, OL2) umfassen, und ein drittes analoges Bandpassfilter (F3_1, F3_2) zum Isolieren des Ergebnisses der Multiplikation.

## Claims

1. A system (SA) for amplifying signals generated by a signal generation unit (UGS) of a satellite, comprising:
- a first channel (V1) comprising a first digital band-pass filter (F1) with finite pulse response for filtering digital signals generated by said unit (UGS) outside of its useful band and a first digital/analogue converter (CNA1) disposed at the output of said first digital filter (F1);
- frequency transposition means (MTF) for converting a signal in base band or in an intermediate frequency into a signal in a carrier band; and
- an amplification device (DA) comprising a pre-amplifier and an amplifier,
**characterised in that** it further comprises:
- a second channel (V2) comprising a second digital band-pass filter (F2) with finite pulse response for filtering digital signals generated by said unit (UGS) outside of its useful band, gain means (G) disposed at the output of said second digital filter (F2), a phase-locked numerically controlled oscillator (NCO) disposed at the output of said gain means (G), and a second digital/analogue converter (CNA2) disposed at the output of said numerically controlled oscillator (NCO); and
- a recombiner device (S) for adding the signals of said first and second channels (V1, V2).

2. The system (SA) according to claim 1, wherein said frequency transposition means (MTF) are disposed between the output of said recombiner device (S) and the input of said amplification device (DA).

3. The system (SA) according to claim 2, wherein said frequency transposition means (MTF) comprise a local oscillator (OL), a mixer (MEL) designed for adding the frequency, by multiplication, of the input signal of said frequency transposition means (MTF) and the output signal of said local oscillator (OL), and a third analogue band-pass filter (F3) for isolating the result of said multiplication.

4. The system (SA) according to claim 1, wherein said frequency transposition means (MTF) comprise:
- first frequency transposition sub-means (MTF1) disposed on said first channel (V1) between the output of said first converter (CNA1) and the input of said adder (S); and
- second frequency transposition sub-means (MTF2) disposed on said second channel (V2) between the output of said second converter (CNA2) and the input of said adder (S).

5. The system (SA) according to claim 4, wherein said first and/or second frequency transposition sub-means (MTF1, MTF2) respectively comprise a local oscillator (OL1, OL2), a mixer (MEL1, MEL2) designed for adding the frequency, by multiplication, of the input signal of said frequency transposition sub-means (MTF1, MTF2) and the output signal of said local oscillator (OL1, OL2), and a third analogue band-pass filter (F3_1, F3_2) for isolating the result of said multiplication.
